# EUROPEAN PATENT APPLICATION

(11) **EP 4 509 953 A1**
(43) Date of publication of application: **19.02.2025**
(21) Application number: 24751970.5
(22) Date of filing: 28.05.2024
(51) Int. Cl.: G06F 1/16, H04M 1/02

(54) **ELECTRONIC DEVICE INCLUDING HINGE**

(30) Priority: 26.06.2023 KR 20230082148; 02.08.2023 KR 20230101076
(71) Applicant: Samsung Electronics Co., Ltd, Suwon-si, Gyeonggi-do 16677 (KR)
(72) Inventor: HA, Seonwoo, Yeongtong-gu, Suwon-si Gyeonggi-do 16677 (KR); PARK, Changhee, Yeongtong-gu, Suwon-si Gyeonggi-do 16677 (KR)
(74) Representative: Gulde & Partner
(86) International application number: PCT/KR2024/007222
(87) International publication number: WO 2025/005493

(57) **Abstract**

An electronic device according to an embodiment may include a display including a first area and a second area, a pair of housings including a first housing supporting the first area and a second housing supporting the second area, a hinge connecting the first housing and the second housing to be foldable about a folding axis, a hinge housing in which at least a portion of the hinge assembly is accommodated, and a sweeper arranged in each of the first housing and the second housing in a direction parallel to the folding axis, so that the first area and the second area contact the hinge housing based on the folded state of facing each other. The sweeper may not contact the hinge assembly.

## Description

### BACKGROUND

### 1. Field

The following description relates to an electronic device including a hinge.

### 2. Description of Related Art

To provide miniaturized and highly functional electronic devices, there is a continuous demand for electronic devices with a variety of designs and functions. For example, to satisfy the purchasing desires of consumers, there are foldable electronic devices that can be changed in size and folded into various shapes, deviating from uniform longitudinal shapes. Foldable electronic devices use hinges to implement a folding operation to change shapes.

However, the foregoing should not be construed as having been acknowledged by the applicant as a prior art to the description set forth in the disclosure, but should be construed only as a related art to the invention described herein.

### SUMMARY

The present invention is defined by the appended set of claims. Further embodiments lying outside the scope of the claims serve illustrative and comparative purpose only.

An electronic device according to an embodiment may include a display including a first area and a second area, a pair of housings including a first housing supporting the first area and a second housing supporting the second area, a hinge connecting the first housing and the second housing to be foldable about a folding axis, a hinge housing in which at least a portion of the hinge assembly is accommodated, and a sweeper arranged in each of the first housing and the second housing in a direction parallel to the folding axis, so that the first area and the second area contact the hinge housing based on the folded state of facing each other. The sweeper may not contact the hinge assembly, at least partially overlap the hinge assembly when viewed in a direction perpendicular to the folding axis, based on the folded state, and have a surface height in a portion overlapping the hinge assembly that is lower than a surface height in a portion non-overlapping the hinge assembly.

An electronic device according to an embodiment may include a display including a first area and a second area, a pair of housings including a first housing supporting the first area and a second housing supporting the second area, a hinge assembly connecting the first housing and the second housing to be foldable about a folding axis, a hinge housing in which at least a portion of the hinge assembly is accommodated, and a sweeper arranged in each of the first housing and the second housing in a direction parallel to the folding axis, so that the first area and the second area contact the hinge housing based on the folded state of facing each other. The first housing and the second housing may each include a seating portion formed in a length direction of the pair of housings parallel to the folding axis so that the sweeper is seated thereon. The sweeper may not contact the hinge assembly, at least partially overlap the hinge assembly when the display is viewed from the pair of housings, based on the folded state, and have a surface height in a portion overlapping the hinge assembly that is lower than a surface height in a portion non-overlapping the hinge assembly.

An electronic device according to an embodiment may include a display including a first area and a second area, a pair of housings including a first housing supporting the first area and a second housing supporting the second area, a hinge assembly connecting the first housing and the second housing to be foldable about a folding axis, a hinge housing in which at least a portion of the hinge assembly is accommodated, and a sweeper arranged in each of the first housing and the second housing in a direction parallel to the folding axis, so that the first area and the second area contact the hinge housing based on the folded state of facing each other. The hinge assembly may include a hinge connected to the hinge housing to be foldable about the folding axis, and a hinge bracket extending from the hinge to the pair of housings and connecting the hinge and the pair of housings. The sweeper may include a first sweeper part overlapping the hinge assembly, and a second sweeper part non-overlapping the hinge assembly. At least a portion of the first sweeper part may have a smaller thickness in the height direction toward the display than the second sweeper part.

### BRIEF DESCRIPTION OF THE DRAWINGS

The above and other aspects, features, and advantages of certain embodiments of the present disclosure will be more apparent from the following detailed description, taken in conjunction with the accompanying drawings, in which:
FIG. 1 is a block diagram of an electronic device in a network environment according to an embodiment.
FIG. 2A is a view illustrating an unfolded state of an electronic device according to an embodiment.
FIG. 2B is a view illustrating a folded state of an electronic device according to an embodiment.
FIG. 3A is an exploded perspective view of an electronic device according to an embodiment.
FIG. 3B is a view schematically illustrating a structure to describe a housing, a hinge assembly, and a sweeper in the electronic device of FIG. 3A.
FIG. 4A is a view illustrating a structure in which a second housing, a hinge housing, a hinge assembly, and a second sweeper member are assembled, in a folded state of an electronic device according to an embodiment.
FIG. 4B is an exploded perspective view to describe an arrangement relationship of a first seating part, a second seating part, and a first sweeper member formed in a first housing according to an embodiment.
FIG. 4C is a cross-sectional view taken along A-A' of FIG. 4A.
FIG. 4D is a cross-sectional view taken along B-B' of FIG. 4A.
FIG. 4E is a cross-sectional view taken along C-C' of FIG. 4A.
FIG. 4F is an enlarged view of an area D of FIG. 4E.
FIG. 5A is a view illustrating a structure in which a second housing, a hinge housing, a hinge assembly, and a second sweeper member are assembled, in a folded state of an electronic device according to an embodiment.
FIG. 5B is an exploded perspective view to describe an arrangement relationship of a first seating part, a second seating part, and a first sweeper member formed in a first housing according to an embodiment.
FIG. 5C is a cross-sectional view taken along E-E' of FIG. 5A.
FIG. 5D is an enlarged view of an area H of FIG. 5C.
FIG. 6A is a perspective view of a second sweeper member according to an embodiment.
FIG. 6B is a cross-sectional view taken along F-F', in a state in which the second sweeper member of FIG. 6A is arranged in the electronic device of FIG. 5A.
FIG. 6C is a cross-sectional view taken along G-G', in a state in which the second sweeper member of FIG. 6A is arranged in the electronic device of FIG. 5A.
FIG. 7A is a perspective view of a second sweeper member according to an embodiment.
FIG. 7B is a cross-sectional view taken along F-F' based on an unfolded state, in a state in which the second sweeper member of FIG. 7A is arranged in the electronic device of FIG. 5A.
FIG. 7C is a cross-sectional view taken along F-F' based on a folded state, in a state in which the second sweeper member of FIG. 7A is arranged in the electronic device of FIG. 5A.
FIG. 8A is a perspective view of a second sweeper member according to an embodiment.
FIG. 8B is a cross-sectional view taken along F-F', in a state in which the second sweeper member of FIG. 8A is arranged in the electronic device of FIG. 5A.
FIG. 8C is a cross-sectional view taken along G-G', in a state in which the second sweeper member of FIG. 8A is arranged in the electronic device of FIG. 5A.

### DETAILED DESCRIPTION

Hereinafter, embodiments will be described in detail with reference to the accompanying drawings. When describing the embodiments with reference to the accompanying drawings, like reference numerals refer to like components, and any repeated description related thereto will be omitted.

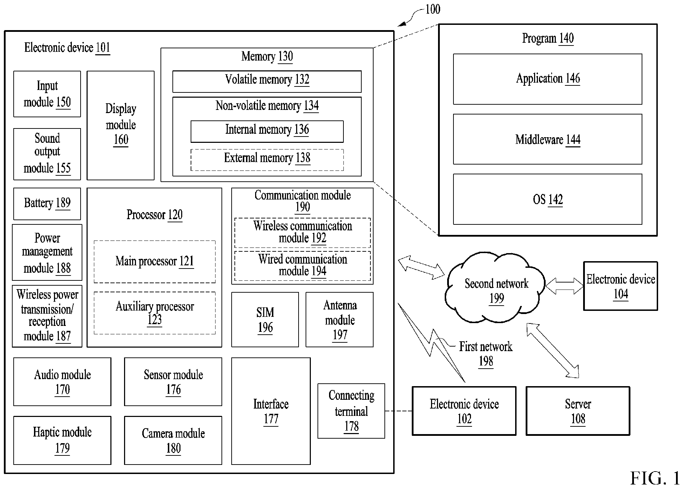

FIG. 1 is a block diagram of an electronic device in a network environment according to various embodiments. Referring to FIG. 1, the electronic device 101 in the network environment 100 may communicate with an electronic device 102 via a first network 198 (e.g., a short-range wireless communication network), or communicate with at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the above components may be omitted from the electronic device 101, or one or more other components may be added in the electronic device 101. In some embodiments, some (e.g., the sensor module 176, the camera module 180, or the antenna module 197) of the components may be integrated as a single component (e.g., the display module 160).

The processor 120 may execute, for example, software (e.g., a program 140) to control at least one other component (e.g., a hardware or software component) of the electronic device 101 connected to the processor 120, and may perform various data processing or computation. According to an embodiment, as at least a portion of data processing or computation, the processor 120 may store a command or data received from another component (e.g., the sensor module 176 or the communication module 190) in a volatile memory 132, process the command or the data stored in the volatile memory 132, and store resulting data in a nonvolatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented as separate from, or as part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state, or together with the main processor 121 while the main processor 121 is an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for artificial intelligence (AI) model processing. An artificial intelligence model may be generated through machine learning. Such learning may be performed, e.g., by the electronic device 101 where the artificial intelligence is performed, or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network, or a combination of two or more thereof, but is not limited thereto. The artificial intelligence model may, additionally or alternatively, include a software structure other than the hardware structure.

The memory 130 may store various pieces of data used by at least one component (e.g., the processor 120 or the sensor module 176) of the electronic device 101. The various data may include, for example, software (e.g., the program 140) and input data or output data for a command related thereto. The memory 130 may include the volatile memory 132 or the nonvolatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing a record. The receiver may be used to receive an incoming call. According to an embodiment, the receiver may be implemented separately from the speaker or as a portion of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to sense a touch, or a pressure sensor adapted to measure an intensity of a force incurred by the touch.

The audio module 170 may convert a sound into an electrical signal or vice versa. According to an embodiment, the audio module 170 may obtain the sound via the input module 150 or output the sound via the sound output module 155 or an external electronic device (e.g., an electronic device 102 such as a speaker or a headphone) directly or wirelessly connected to the electronic device 101.

The sensor module 176 may detect an operational state (e.g., power or temperature) of the electronic device 101 or an environmental state (e.g., a state of a user) external to the electronic device 101, and generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or an electrical stimulus which may be recognized by a user via his or her tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a portion of a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that operate independently of the processor 120 (e.g., an application processor) and support direct (e.g., wired) communication or wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., a LAN or a wide area network (WAN))). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a fourth-generation (4G) network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., an external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or the power may be transmitted or received between the communication module 190 and the external electronic device via the selected at least one antenna. According to an embodiment, another component (e.g., a radio frequency integrated circuit (RFIC)) other than the radiating element may be additionally formed as a portion of the antenna module 197.

According to various embodiments, the antenna module 197 may form a mmWave antenna module. According to an embodiment, the mmWave antenna module may include a PCB, a RFIC disposed on a first surface (e.g., the bottom surface) of the PCB or adjacent to the first surface and capable of supporting a designated high-frequency band (e.g., the mmWave band), and a plurality of antennas (e.g., array antennas) disposed on a second surface (e.g., the top or a side surface) of the PCB, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of a same type as, or a different type from, the electronic device 101. According to an embodiment, all or some of operations to be executed by the electronic device 101 may be executed at one or more of external electronic devices (e.g., the external electronic devices 102 and 104, or the server 108). For example, if the electronic device 101 needs to perform a function or a service automatically, or in response to a request from a user or another device, the electronic device 101, instead of, or in addition to, executing the function or the service, may request one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. according to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to embodiments may be one of various types of electronic devices. The electronic devices may include, for example, a portable communication device (e.g., a smart phone), a computer device, a portable multimedia device, a portable medical device, a camera, a wearable device, or a home appliance. According to an embodiment of the disclosure, the electronic devices are not limited to those described above.

It should be appreciated that embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related components. It is to be understood that a singular form of a noun corresponding to an item may include one or more of the things, unless the relevant context clearly indicates otherwise. As used herein, "A or B", "at least one of A and B", "at least one of A or B", "A, B or C", "at least one of A, B and C", and "at least one of A, B, or C", each of which may include any one of the items listed together in the corresponding one of the phrases, or all possible combinations thereof. Terms such as "first", "second", or "first" or "second" may simply be used to distinguish the component from other components in question, and do not limit the components in other aspects (e.g., importance or order). It is to be understood that if a component (e.g., a first component) is referred to, with or without the term "operatively" or "communicatively", as "coupled with," "coupled to," "connected with," or "connected to" another component (e.g., a second component), it means that the component may be coupled with the other component directly (e.g., wiredly), wirelessly, or via a third component.

As used in connection with various embodiments of the disclosure, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to embodiments, one or more of the above-described components or operations may be omitted, or one or more other components or operations may be added. Alternatively or additionally, a plurality of components (e.g., modules or programs) may be integrated into a single component. **In** such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

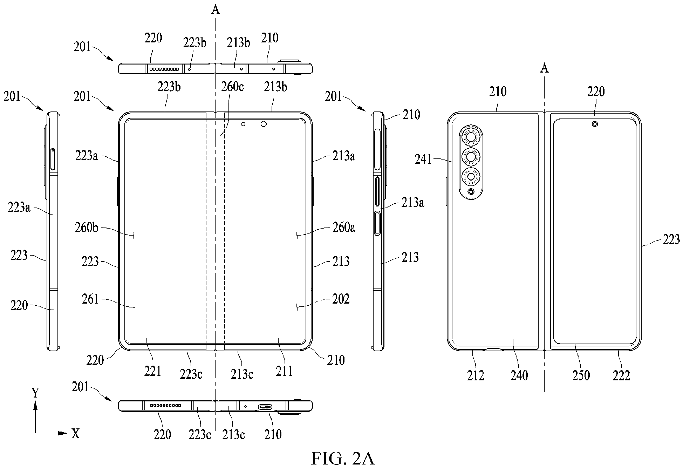

In FIG. 2A and other following drawings, illustrated is a spatial coordinate system defined by the X-axis, the Y-axis, and the Z-axis that are orthogonal to each other. The X-axis may represent the width direction of an electronic device, the Y-axis may represent the length direction of the electronic device, and the Z-axis may represent the height (or thickness) direction of the electronic device.

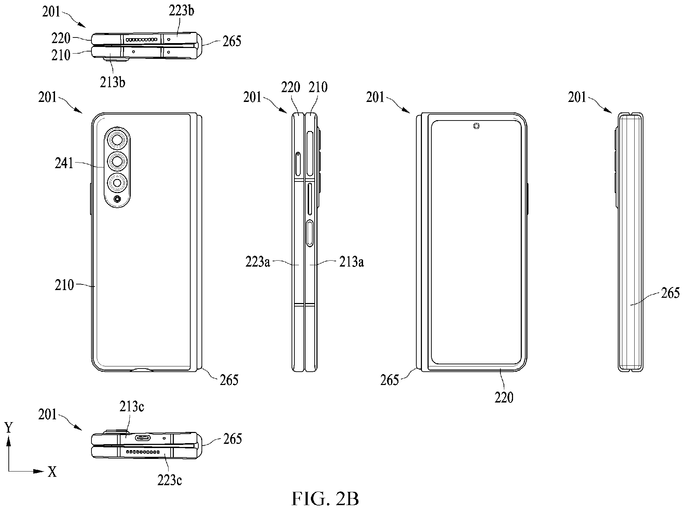

FIG. 2A is a view illustrating an unfolded state of an electronic device according to an embodiment, and FIG. 2B is a view of a folded state of the electronic device according to an embodiment.

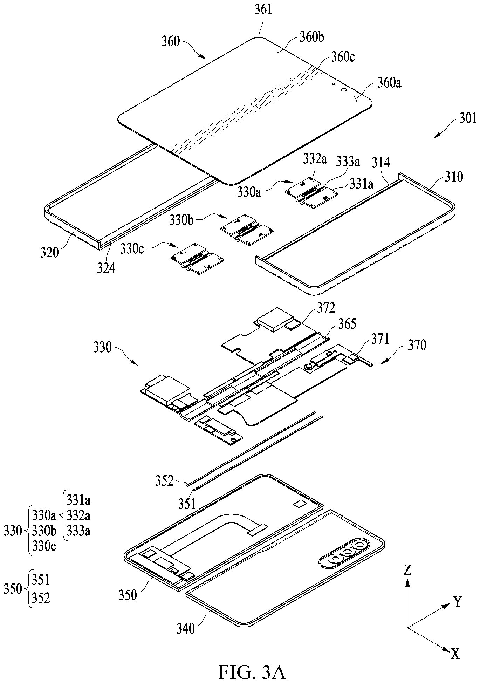

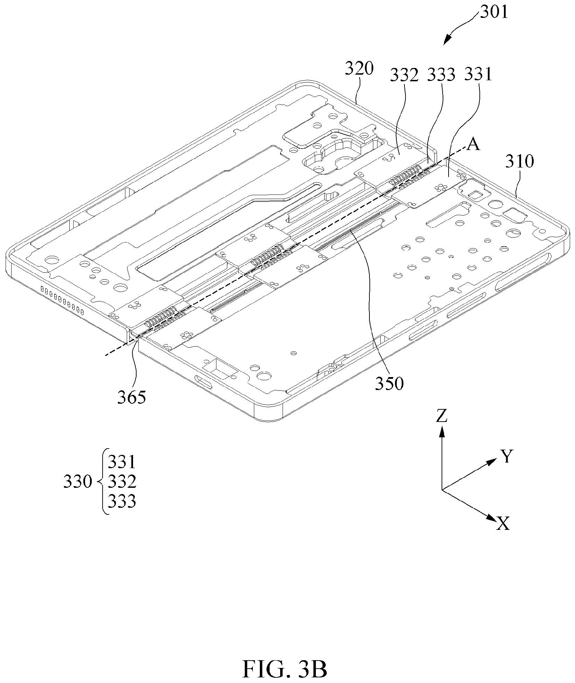

Referring to FIGS. 2A and 2B, an electronic device 201 according to an embodiment may include a pair of housings 210 and 220 rotatably coupled to each other through a hinge (e.g., a hinge 333 of FIGS. 3A and 3B) to be folded with respect to each other, a hinge housing 265 for covering foldable portions of the pair of housings 210 and 220, and a display 260 (e.g., a flexible display or a foldable display) disposed in a space formed by the pair of housings 210 and 220.

A surface on which the display 260 is arranged (or a surface on which the display 260 is visually visible from the outside), of the electronic device 201 according to an embodiment, may be defined as the front surface of the electronic device 201, and a surface opposite to the front surface thereof may be defined as the rear surface of the electronic device 201. A surface surrounding a space between the front surface and the rear surface may be defined as a side surface of the electronic device 201.

In an embodiment, the pair of housings 210 and 220 may include a first housing 210, a second housing 220, a first rear cover 240-1, and a second rear cover 240-2. The pair of housings 210 and 220 of the electronic device 201 are not limited to the shapes or the combination and/or coupling of components shown in FIGS. 2A and 2B, and may be implemented in other shapes or by another combination and/or coupling of components.

In an embodiment, the first housing 210 and the second housing 220 may be disposed on both sides with respect to a folding axis A, and may be disposed substantially symmetrically with respect to the folding axis A. In an embodiment, an angle or a distance between the first housing 210 and the second housing 220 may vary depending on the state of the electronic device 201. For example, depending on whether the electronic device 201 is in an unfolded state as in FIG. 2A, a folded state as in FIG. 2B, or an intermediate state between the unfolded state and the folded state, the distance between the first housing 210 and the second housing 220 or the angle formed by the first housing 210 and the second housing 220 may vary. In an embodiment, the first housing 210 and the second housing 220 may have substantially symmetrical shapes.

In an embodiment, the first housing 210 may be connected to the hinge (e.g., the hinge 333 of FIGS. 3A and 3B) in the unfolded state of the electronic device 201. The first housing 210 may include a first surface 211 facing the front surface of the electronic device 201, a second surface 212 facing a direction opposite to the first surface 211, and a first side portion 213 enclosing at least a portion of a space between the first surface 211 and the second surface 212. The first side member 213 may include a first side surface 213a disposed substantially in parallel with the folding axis A, a second side surface 213b extending in a direction substantially perpendicular to the folding axis A from one end of the first side surface 213a, and a third side surface 213c extending in a direction substantially perpendicular to the folding axis A from another end of the first side surface 213a and substantially parallel to the second side surface 213b.

In an embodiment, the second housing 220 may be connected to the hinge (e.g., the hinge 333 of FIGS. 3A and 3B) in the unfolded state of the electronic device 201. The second housing 220 may include a third surface 221 facing the front surface of the electronic device 201, a fourth surface 222 facing a direction opposite to the third surface 221, and a second side portion 223 enclosing at least a portion of a space between the third surface 221 and the fourth surface 222. The second side member 223 may include a fourth side surface 223a disposed substantially in parallel with the folding axis A, a fifth side surface 223b extending in a direction substantially perpendicular to the folding axis A from one end of the fourth side surface 223a, and a sixth side surface 223c extending in a direction substantially perpendicular to the folding axis A from another end of the fourth side surface 223a and substantially parallel to the fifth side surface 223b. The first surface 211 and the third surface 221 may face each other when the electronic device 201 is in the folded state.

In an embodiment, the electronic device 201 may include at least one sound output module (e.g., the sound output module 155 of FIG. 1) disposed on the fifth side surface 223b and/or the sixth side surface 223c of the second housing 220.

In an embodiment, the electronic device 201 may include a recessed accommodating portion 202 for accommodating the display 260 through the structural coupling of the first housing 210 and the second housing 220. The accommodating portion 202 may have substantially the same size as the display 260.

In an embodiment, at least a portion of the first housing 210 and the second housing 220 may be formed of a metal material or a non-metal material having a predetermined magnitude of rigidity appropriate to support the display 260.

In an embodiment, the electronic device 201 may include at least one component disposed to be exposed on the front surface of the electronic device 201 to perform various functions. For example, the component may include at least one of a front camera module, a receiver, a proximity sensor, an illuminance sensor, an iris recognition sensor, an ultrasonic sensor, or an indicator.

In an embodiment, the first rear cover 240-1 may be disposed on the second surface 212 of the first housing 210, and may have a substantially rectangular periphery. At least a portion of the periphery of the first rear cover 240-1 may be surrounded by the first housing 210. The second rear cover 240-2 may be disposed on the fourth surface 222 of the second housing 220, and may have a substantially rectangular periphery. At least a portion of the periphery of the second rear cover 240-2 may be surrounded by the second housing 220.

In an embodiment, the first rear cover 240-1 and the second rear cover 240-2 may have substantially symmetrical shapes with respect to the folding axis A. In an embodiment, the first rear cover 240-1 and the second rear cover 240-2 may have different shapes. In an embodiment, the first housing 210 and the first rear cover 240-1 may be integrally formed, and the second housing 220 and the second rear cover 240-2 may be integrally formed.

In an embodiment, the first housing 210, the second housing 220, the first rear cover 240-1, and the second rear cover 240-2 may provide a space in which various components (e.g., a PCB, the antenna module 197 of FIG. 1, the sensor module 176 of FIG. 1, or the battery 189 of FIG. 1) of the electronic device 201 may be arranged through a structure in which the first housing 210, the second housing 220, the first rear cover 240, and the second rear cover 250 are coupled to one another. In an embodiment, at least one component may be visually exposed on the rear surface of the electronic device 201. For example, at least one component may be visually exposed through a first rear area 241 of the first rear cover 240-1. Here, the component may include a proximity sensor, a rear camera module, and/or a flash.

In an embodiment, the display 260 may be disposed in the accommodating portion 202 formed by the pair of housings 210 and 220. For example, the display 260 may be arranged to occupy substantially most of the front surface of the electronic device 201. The front surface of the electronic device 201 may include an area in which the display 260 is disposed, and a partial area (e.g., a periphery area) of the first housing 210 and a partial area (e.g., a periphery area) of the second housing 220, which are adjacent to the display 260. The rear surface of the electronic device 201 may include the first rear cover 240-1, a partial area (e.g., a periphery area) of the first housing 210 adjacent to the first rear cover 240-1, the second rear cover 240-2, and a partial area (e.g., a periphery area) of the second housing 220 adjacent to the second rear cover 240-2. In an embodiment, at least a partial area of the display 260 may be deformed into a planar surface or a curved surface.

In an embodiment, at least a partial area of the display 260 may be deformed. In an embodiment, the display 260 may include a folding area 260c, a first area 260a on a first side (e.g., the right side of the folding area 260c of FIG. 2A) of the folding area 260c, and a second area 260b on a second side (e.g., the left side of the folding area 260c of FIG. 2A) of the folding area 260c. In an embodiment, the first area 260a of the display 260 may be supported by the first housing 210, and the second area 260b of the display 260 may be supported by the second housing 220. However, the area division of the display 260 shown in the drawings is merely an example, and the display 260 may be divided into a plurality of areas depending on the structure or functions of the display 260. For example, as shown in FIG. 2A, the display 260 may be divided into areas based on the folding axis A or the folding area 260c extending parallel to the Y-axis, or the display 260 may be divided into areas based on another folding area (e.g., a folding area extending parallel to the X-axis) or another folding axis (e.g., a folding axis parallel to the X-axis). The area division of the display 260 as above is merely a physical division based on the pair of housings 210 and 220 and the hinge (e.g., the hinge 333 of FIGS. 3A and 3B), and the display 260 may display substantially one screen through the pair of housings 210 and 220 and the hinge (e.g., the hinge 333 of FIGS. 3A and 3B). In an embodiment, the first area 260a and the second area 260b may have substantially symmetrical shapes with respect to the folding area 260c. In an embodiment, a notch that is at least a partial cut to expose a sensor may be formed in at least one of the first area 260a and the second area 260b. For example, the first area 260a and the second area 260b may include mutually symmetrical portions and mutually asymmetrical portions.

According to various embodiments in the disclosure, the display 260 may be coupled to or disposed adjacent to a touch panel in which a touch sensing circuit and a pressure sensor configured to measure an intensity (or pressure) of a touch are provided. For example, the display 260 is an example of a touch panel, and may be coupled to or disposed adjacent to a touch panel for detecting an electromagnetic resonance (EMR) type stylus pen.

In an embodiment, the hinge housing 265 may be arranged between the first housing 210 and the second housing 220 and configured to cover the hinge (e.g., the hinge 333 of FIGS. 3A and 3B). The hinge housing 265 may be hidden by at least a portion of the first housing 210 and the second housing 220 or exposed to the outside according to the operational state of the electronic device 201. For example, when the electronic device 201 is in an unfolded state as shown in FIG. 2A, the hinge housing 265 may be hidden by the first housing 210 and the second housing 220 and not exposed to the outside, and when the electronic device 201 is in a folded state as shown in FIG. 2B, the hinge housing 265 may be exposed to the outside between the first housing 210 and the second housing 220. Meanwhile, when the electronic device 201 is in an intermediate state in which the first housing 210 and the second housing 220 form an angle with each other, at least a portion of the hinge housing 265 may be exposed to the outside between the first housing 210 and the second housing 220. In this case, an area of the hinge housing 265 exposed to the outside may be smaller than the area of the hinge housing 265 exposed when the electronic device 201 is in the folded state. In an embodiment, the hinge housing 265 may have a curved surface.

Describing the operation of the electronic device 201 according to an embodiment, when the electronic device 201 is in an unfolded state (e.g., the state of the electronic device 201 of FIG. 2A), the first housing 210 and the second housing 220 may form a first angle (e.g., about 180 degrees) with each other, and the first area 260a and the second area 260b of the display 260 may be oriented in substantially the same direction. The folding area 260c of the display 260 may be on substantially the same plane as the first area 260a and the second area 260b. In an embodiment, when the electronic device 201 is in the unfolded state, the first housing 210 may rotate at a second angle (e.g., about 360 degrees) relative to the second housing 220, whereby the first housing 210 and the second housing 220 may be reversely folded such that the second surface 212 and the fourth surface 222 may face each other. Meanwhile, when the electronic device 201 is in the folded state (e.g., the state of the electronic device 201 of FIG. 2B), the first housing 210 and the second housing 220 may face each other. The first housing 210 and the second housing 220 may form an angle of about 0 degrees to about 10 degrees, and the first area 260a and the second area 260b of the display 260 may face each other. At least a portion of the folding area 260c of the display 260 may be deformed into a curved surface. Meanwhile, when the electronic device 201 is in the intermediate state, the first housing 210 and the second housing 220 may form a predetermined angle with each other. An angle (e.g., a third angle, about 90 degrees) formed by the first area 260a and the second area 260b of the display 260 may be greater than that when the electronic device 201 is in the folded state and less than that when the electronic device 201 is in the unfolded state. At least a portion of the folding area 260c of the display 260 may be deformed into a curved surface. In this case, a curvature of the curved surface of the folding area 260c may be smaller than that when the electronic device 201 is in the folded state.

Meanwhile, the various embodiments of the electronic device described in the disclosure are not limited to the form factor of the electronic device 201 described with reference to FIGS. 2A and 2B, and may also apply to electronic devices with various form factors.

FIG. 3A is an exploded perspective view of an electronic device according to an embodiment, and FIG. 3B is a view schematically illustrating a structure to describe a housing, a hinge assembly, and a sweeper in the electronic device of FIG. 3A.

Referring to FIGS. 3A and 3B, an electronic device 301 according to various embodiments may include a display 360 (e.g., the display module 160 of FIG. 1), a hinge assembly 330, a sweeper 350, a substrate 370, a first housing 310 (e.g., the first housing 210 of FIGS. 2A and 2B), a second housing 320 (e.g., the second housing 220 of FIGS. 2A and 2B), a first rear cover 340-1 (e.g., the first rear cover 240-1 of FIGS. 2A and 2B), and a second rear cover 340-2 (e.g., the second rear cover 240-2 of FIGS. 2A and 2B).

In an embodiment, the display 360 may include a display panel 361 (e.g., a flexible display panel) and at least one layer or plate 362 arranged on the rear surface of the display panel 361.

In an embodiment, the display panel 361 may include a flexible display substrate, a plurality of display elements coupled to the display substrate to form multiple pixels, one or more conductive lines coupled to the display substrate and electrically connected to other display elements, and a thin-film encapsulation layer configured to prevent or reduce an inflow of external oxygen and moisture. In one embodiment, the display panel 361 may include a touch panel or may be integrally formed therewith.

The display substrate may be formed of a flexible material, for example, a plastic material such as polyimide (PI), but the material of the display substrate is not limited thereto and may include various materials having flexible properties. The plurality of display elements may be arranged on the display substrate and form some pixels. For example, the plurality of display elements may be arranged in a matrix form on the display substrate to form pixels of the display panel 361. For example, the plurality of display elements may include a fluorescent material or an organic fluorescent material capable of expressing colors. For example, the display elements may include organic light emitting diodes (OLEDs). The conductive lines may include one or more gate signal lines or one or more data signal lines. For example, the conductive lines may include a plurality of gate signal lines and a plurality of data signal lines, and the plurality of gate signal lines and the plurality of data signal lines may be arranged in a matrix form. For example, the plurality of display elements may be arranged adjacent to a point where a plurality of lines intersect, and may be electrically connected to each line. The thin film encapsulation layer may cover the display substrate, the plurality of display elements, and the conductive lines, thereby preventing or reducing an inflow of oxygen and moisture from an outside. In an embodiment, the thin film encapsulation layer may be formed by alternately stacking one or more organic film layers and one or more inorganic film layers.

In an embodiment, the touch panel may be formed as an integral body on the display panel 361 or attached thereto. For example, the touch panel may be formed by patterning an aluminum metal mesh sensor on the thin film encapsulation layer of the display panel 361.

In an embodiment, the polarizing film may be stacked between the display panel 361 and the touch panel. The polarizing film may improve the visibility of the display 360. The polarizing film may change a phase of light passing through the display 360. For example, the polarizing film may convert linearly polarized light into circularly polarized light or convert circularly polarized light into linearly polarized light, thereby preventing or reducing reflection of light incident to the display panel 361.

The window layer may be formed of a transparent plastic film having high flexibility and high hardness. For example, the window layer may be formed of a polyimide (PI) or polyethylene terephthalate (PET) film. In an embodiment, the window layer may be formed as multiple layers including a plurality of plastic films.

In an embodiment, the plate 362 may support the rear surface of the display panel 361, thereby improving the impact resistance of the display panel 361. In an embodiment, the plate 362 may be divided into areas to support a rear surface of a first area 360a and a rear surface of a second area 360b of the display 360, respectively. For example, the respective areas of the plate 362 may be separately attached to the rear surface of the first area 360a and the rear surface of the second area 360b of the display 360 so as not to contact each other along the folding axis A. According to this structure, the plate 362 may not interfere with the folding operation of the display 360 performed along the folding axis A.

In an embodiment, the plate 362 may be formed of a conductive material, for example, copper or an alloy material including copper. For example, the plate 362 may function as a heat transfer path that transfers heat generated in an internal component (e.g., an application processor (AP)) in the electronic device 301 to the display panel 361, at the same time improving the impact resistance of the display 360.

The hinge assembly 330 according to an embodiment may include hinge brackets 331 and 332 including a first hinge bracket 331 and a second hinge bracket 332, a hinge 333 arranged between the first hinge bracket 331 and the second hinge bracket 332, and a hinge housing 365 covering the hinge 333 when the hinge 333 is viewed from the outside.

In an embodiment, the hinge assembly 330 may be arranged between the plate 362 and the substrate 370. As an example, the first hinge bracket 331 may be arranged between the first area 360a of the display panel 361 and a first substrate 371. The second hinge bracket 332 may be arranged between the second area 360b of the display panel 361 and a second substrate 372.

The hinge 333 according to an embodiment may be disposed in the hinge housing 365 along the folding axis A and perform the folding operation about the folding axis A. The hinge brackets 331 and 332 according to an embodiment may connect the hinge 333 and the pair of housings 310 and 320, respectively. For example, the hinge brackets 331 and 332 may connect the first housing 310 and the hinge 333 and connect the second housing 320 and the hinge 333, so that the pair of housings 310 and 320 may be folded about the folding axis A as the folding operation is performed by the hinge 333.

The hinge assembly 330 according to an embodiment may be provided in plurality. For example, the plurality of hinge assemblies 330 may include a first hinge assembly 330a, a second hinge assembly 330b, and a third hinge assembly 330c. At least one (e.g., the first hinge assembly 330a) of the plurality of hinge assemblies according to an embodiment may include a hinge 333a, a first hinge bracket 331a, and a second hinge bracket 332a. Each of the plurality of hinge assemblies 330a, 330b, and 330c according to an embodiment may be arranged in the hinge housing 365 to be spaced apart from each other along the folding axis. For example, the first hinge assembly 330a may connect the midpoint on one side of the first housing 310 parallel to the folding axis A and the midpoint on one side of the second housing 320 parallel to folding axis A, and the second hinge assembly 330b and the third hinge assembly 330c may be arranged in opposite directions based on the first hinge assembly 330a. However, the above description is only for ease of description, and the number of hinge assemblies 330 arranged in the electronic device according to an embodiment is not limited thereto, and may be one, two, or three or more.

In an embodiment, the sweeper 350 may fill the gaps formed between the hinge housing 365 and the pair of housings 310 and 320. The sweeper 350 may prevent or reduce an inflow of a foreign substance into the hinge housing 365 and the pair of housings 310 and 320. In an embodiment, the sweeper 350 may be arranged in the pair of housings 310 and 320. In an embodiment, the sweeper 350 may include a first sweeper member 351 arranged between the first housing 310 and the hinge housing 365, and a second sweeper member 352 arranged between the second housing 320 and the hinge housing 365. The sweeper 350 will be described in detail later.

The substrate 370 may include the first substrate 371 arranged on the first hinge bracket 331 and the second substrate 372 arranged on the second hinge bracket 332. The first substrate 371 and the second substrate 372 may be disposed in a space formed by the hinge assembly 330, the first housing 310, the second housing 320, the first rear cover 340-1, and the second rear cover 340-2. Components for implementing various functions of the electronic device 301 may be arranged on the first substrate 371 and the second substrate 372.

The first housing 310 and the second housing 320 may be rotatably assembled on both sides of the hinge assembly 330. In an embodiment, the first housing 310 may include a first support surface 314, and the second housing 320 may include a second support surface 324 corresponding to the first support surface 314. The first support surface 314 and the second support surface 324 may include curved surfaces corresponding to the curved surface included in the hinge housing 365.

In an embodiment, when the electronic device 301 is in an unfolded state (e.g., the electronic device 201 of FIG. 2A), the first support surface 314 and the second support surface 324 may cover the hinge housing 365, such that the hinge housing 365 may not be exposed or minimally exposed through the rear surface of the electronic device 301. Meanwhile, when the electronic device 301 is in a folded state (e.g., the electronic device 201 of FIG. 2B), the first support surface 314 and the second support surface 324 may rotate along the curved surface included in the hinge housing 365, such that the hinge housing 365 may be maximally exposed through the rear surface of the electronic device 301.

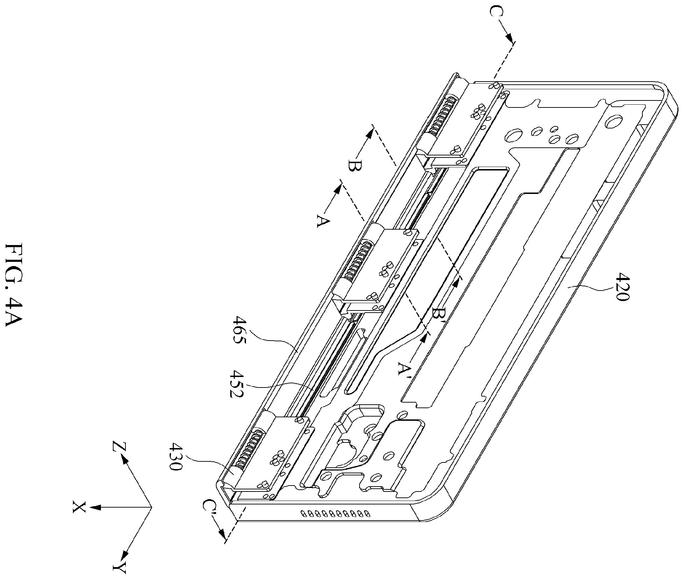

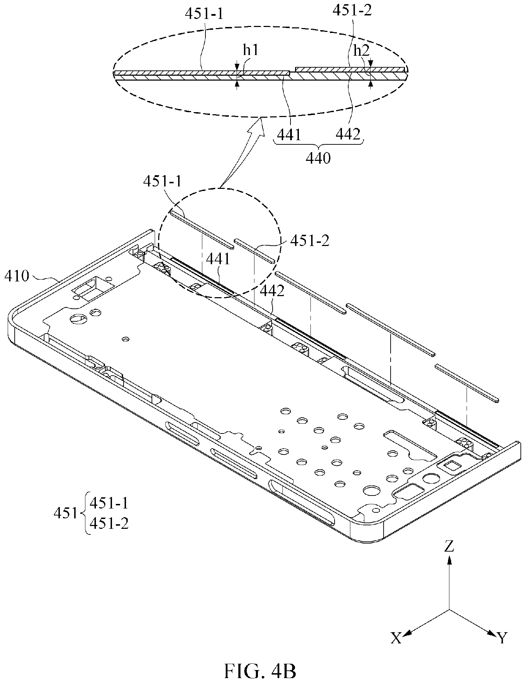

In FIG. 4A and other following drawings, illustrated is a spatial coordinate system defined by the X-axis, the Y-axis, and the Z-axis that are orthogonal to each other. The X-axis may denote the width direction of an electronic device, a pair of housings, and a sweeper, the Y-axis denote the length direction of the electronic device, the pair of housings, and the sweeper, and the Z-axis may denote the height (or thickness) direction of the electronic device, the pair of housings, and the sweeper. The structures applied to a second housing shown in FIG. 4A and a first housing shown in FIG. 4B may be equally applied to the first housing and the second housing, respectively.

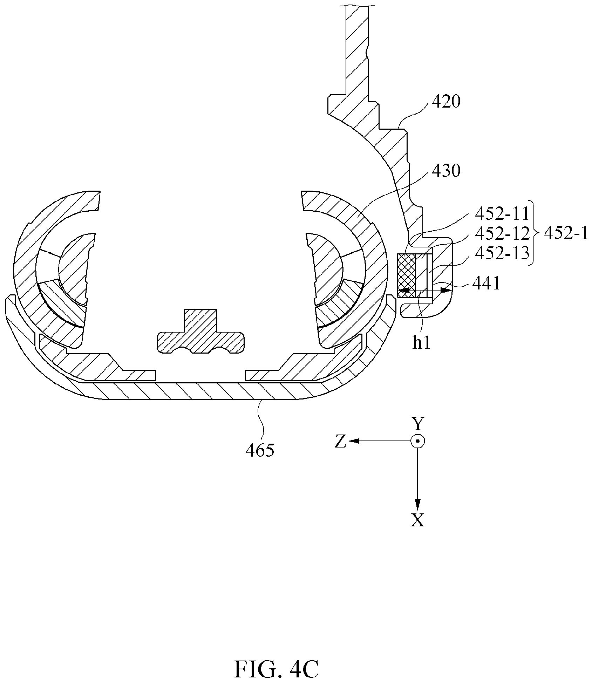

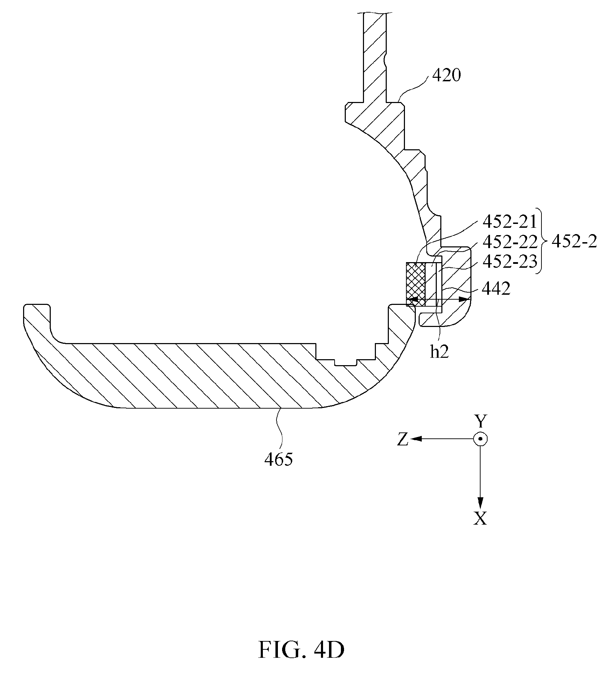

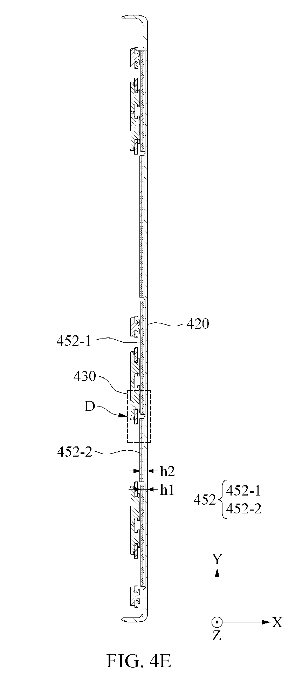

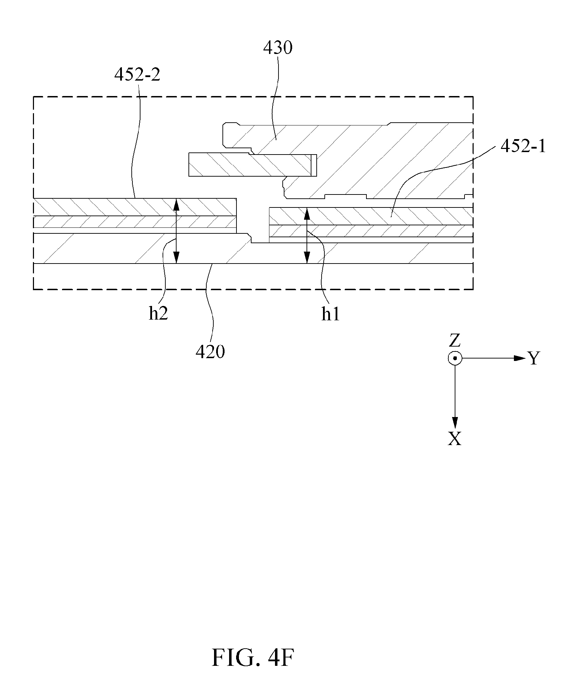

FIG. 4A is a view illustrating a structure in which a second housing, a hinge housing, a hinge assembly, and a second sweeper member are assembled, in a folded state of an electronic device according to an embodiment, FIG. 4B is an exploded perspective view to describe an arrangement relationship of a first seating part, a second seating part, and a first sweeper member formed in a first housing according to an embodiment, FIG. 4C is a cross-sectional view taken along A-A' of FIG. 4A, FIG. 4D is a cross-sectional view taken along B-B' of FIG. 4A, FIG. 4E is a cross-sectional view taken along C-C' of FIG. 4A, and FIG. 4F is an enlarged view of an area D of FIG. 4E.

Referring to FIGS. 4A to 4F, an electronic device (e.g., the electronic device 301 of FIG. 3A) according to an embodiment may include a display (e.g., the display 360 of FIG. 3A) including a first area (e.g., the first area 360a of FIG. 3A) and a second area (e.g., the second area 360b of FIG. 3A), a pair of housings 410 and 420 including a first housing 410 supporting the first area and a second housing 420 supporting the second area, a hinge housing 465, a hinge assembly 430 at least partially accommodated in the hinge housing 465 and foldably connecting the pair of housings 410 and 420, and sweepers 451 and 452 (e.g., the sweeper 350 of FIG. 3A) for filling the gaps formed between the hinge housing 465 and the pair of housings 410 and 420.

The display according to an embodiment may be folded based on a folding axis (e.g., the folding axis A of FIG. 3B) parallel to the Y-axis. The display according to an embodiment may be defined as the first area and the second area based on the folding axis.

The pair of housings 410 and 420 according to an embodiment may form the exterior of the electronic device. The pair of housings 410 and 420 according to an embodiment may include the first housing 410 supporting the first area of the display and the second housing 420 supporting the second area of the display. The pair of housings 410 and 420 according to an embodiment may be connected to be foldable about the folding axis.

The hinge housing 465 according to an embodiment may be arranged between the first housing 410 and the second housing 420 along the folding axis. In the hinge housing 465 according to an embodiment, the hinge assembly 430 may be accommodated, which will be described later. For example, the hinge housing 465 may provide space to accommodate at least a portion of the hinge assembly 430. The hinge housing 465 according to an embodiment may protect the hinge assembly 430 from external impact.

In an embodiment, the hinge assembly 430 may be arranged between the first housing 410 and the second housing 420 and foldably connect the first housing 410 and the second housing 420. For example, the hinge assembly 430 may perform a folding operation so that the first housing 410 and the second housing 420 may be positioned between a folded state (e.g., the state in FIG. 4A) in which the first area and the second area of the display face each other and an unfolded state (e.g., the state in FIG. 4B) in which the first area and the second area do not face. For example, when the hinge assembly 430 is folded based on a folding axis (e.g., the axis parallel to the Y-axis of FIG. 4A), the first housing 410 and the second housing 420 may be folded about the folding axis, and the electronic device may be placed in the folded state. When the hinge assembly 430 is unfolded based on the folding axis, the first housing 410 and the second housing 420 may be unfolded about the folding axis, and the electronic device may be placed in the unfolded state.

In an embodiment, the sweepers 451 and 452 may fill the gaps formed between the pair of housings 410 and 420 and the hinge housing 465, and prevent or reduce an inflow of a foreign substance between the pair of housings 410 and 420 and the hinge housing 465. In an embodiment, the sweepers 451 and 452 may include bases 452-12 and 452-13 adhered to the housings 410 and 420, mohair 452-11 and 452-21 mounted on the bases to fill the gaps between the housings 410 and 420 and the hinge housing 465, and adhesive members 452-13 and 452-23 (e.g., double-sided tapes) to adhere the bases 452-12 and 452-13 to the housings 410 and 420. In an embodiment, the sweepers 451 and 452 may include a flexible material. For example, the sweepers 451 and 452 may include a material of at least one of silicone, rubber, and polyurethane.

In an embodiment, the sweepers 451 and 452 may be arranged in the first housing 410 and the second housing 420, respectively, so that the sweepers may contact the hinge housing 465. The sweepers 451 and 452 according to an embodiment may not contact the hinge assembly 430. For example, the sweepers 451 and 452 may partially contact the hinge housing 465 to fill the gaps between the hinge housing 465 and the pair of housings 410 and 420 while maintaining the non-contact state with the hinge assembly 430. For example, the sweepers 451 and 452 may include, based on the folded state of the electronic device in which the first housing 410 and the second housing 420 face each other, overlapping parts (e.g., first sweeper parts 451-1 and 452-1) positionally overlapping, but not directly contacting, the hinge assembly 430, and non-overlapping parts (e.g., second sweeper parts 451-2 and 452-2) positionally non-overlapping, and not directly contacting, the hinge assembly 430.

In an embodiment, in a state in which the sweepers 451 and 452 are arranged in the housings 410 and 420, the surface height of the sweepers 451 and 452 (e.g., the surface height of the sweepers 451 and 452 in the +Z-axis direction of FIG. 4B) may be different for each part depending on whether the sweepers 451 and 452 overlap the hinge assembly 430, based on the direction perpendicular to the folding axis A (e.g., the Z-axis direction of FIG. 4B). For example, the surface height h1 of the first sweeper parts 451-1 and 452-1 overlapping the hinge assembly 430 may be lower than the surface height h2 of the second sweeper parts 451-2 and 452-2 not overlapping the hinge assembly 430. In an embodiment, as the surface heights h1 and h2 of the sweepers 451 and 452 are formed low in the parts overlapping the hinge assembly 430, the sweepers 451 and 452 may not contact the hinge assembly 430 and thus, may fill the gaps between the housings 410 and 420 and the hinge housing 465 without interfering with the operation of the hinge assembly 430.

The sweepers 451 and 452 according to an embodiment may be arranged on respective one sides of the pair of housings 410 and 420, for example, one sides of the pair of housings 410 and 420 adjacent to the hinge housing 465. The sweepers 451 and 452 according to an embodiment may be arranged in the first housing 410 and the second housing 420, respectively, in the length direction of the housings 410 and 420 (e.g., the Y-axis direction of FIG. 4B) parallel to the folding axis. The sweepers 451 and 452 according to an embodiment may include a first sweeper member 451 arranged in the first housing 410 and a second sweeper member 452 arranged in the second housing 420.

In the following description, for ease of description, the first sweeper member 451 and the second sweeper member 452 will be collectively referred to as sweepers. Unless otherwise specified, the first sweeper member 451 and the second sweeper member 452 may be construed as having symmetrical shapes about the folding axis. However, the first sweeper member 451 and the second sweeper member 452 do not necessarily have symmetrical shapes and may have different structures or include different materials.

In an embodiment, the sweepers 451 and 452 may include first sweeper parts 451-1 and 452-1 arranged in portions where the housings 410 and 420 overlap the hinge assembly 430 and second sweeper parts 451-2 and 452-2 arranged in portions where the housings 410 and 420 do not overlap the hinge assembly 430. The first sweeper parts 451-1 and 452-1 and the second sweeper parts 451-2 and 452-2 according to an embodiment may be formed integrally or separately. The first sweeper parts 451-1 and 452-1 and the second sweeper parts 451-2 and 452-2 according to an embodiment may be the same or different in thickness in the height direction (e.g., thickness in the +Z-axis direction of FIG. 4C).

The first sweeper parts 451-1 and 452-1 and the second sweeper parts 451-2 and 452-2 according to an embodiment may be separate members or may be formed integrally as one member. **In** an embodiment, the first sweeper parts 451-1 and 452-1 and the second sweeper parts 451-2 and 452-2 may include different materials. For example, the first sweeper parts 451-1 and 452-1 may include a less dense material than the second sweeper parts 451-2 and 452-2.

In an embodiment, at least a portion of the sweepers 451 and 452 may overlap the hinge assembly 430, and the corresponding portion may include a less dense material than the portion not overlapping the hinge assembly 430. **In** an embodiment, when the hinge assembly 430 and the sweepers 451 and 452 are in contact, at least a portion of the sweepers 451 and 452 contacting the hinge assembly 430 has a relatively low contact degree due to its lower density than the other portion, and thus, damage due to contact may be prevented or reduced.

In an embodiment, a seating portion 440 may be formed in each of the first housing 410 and the second housing 420. The seating portion 440 according to an embodiment may be formed on one side of each of the first housing 410 and the second housing 420 adjacent to the hinge housing 465. For example, the seating portion 440 may be formed on one side of the first housing 410 facing the hinge housing 465 (e.g., one side of the first housing 410 facing the -X-axis direction of FIG. 4C). The seating portion 440 according to an embodiment may be formed in the length direction of the pair of housings 410 and 420 (e.g., the Y-axis direction of FIG. 4B) parallel to the folding axis. In an embodiment, the seating portion 440 may include a space for accommodating the sweepers 451 and 452 to seal the gaps between the hinge housing 465 and the pair of housings 410 and 420. The sweepers 451 and 452 may be arranged on the seating portion 440 according to an embodiment. In an embodiment, when the sweepers 451 and 452 are arranged on the seating portion 440, the surface height of the sweepers 451 and 452 may be formed lower at the parts overlapping the hinge assembly 430 than the parts not overlapping the hinge assembly 430, based on the height direction of the sweepers 451 and 452.

In an embodiment, the seating portion 440 may include a first seating part 441 formed in portions where the housings 410 and 420 and the hinge assembly 430 overlap, and a second seating part 442 formed in portions where the housings 410 and 420 and the hinge assembly 430 do not overlap.

In an embodiment, the sweepers 451 and 452 may be arranged on the first seating part 441 and the second seating part 442, respectively. For example, the first sweeper parts 451-1 and 452-1 may be arranged on the first seating part 441, and the second sweeper parts 451-2 and 452-2 may be arranged on the second seating part 442.

In describing the embodiment of FIGS. 4A to 4F, the first sweeper parts 451-1 and 452-1 and the second sweeper parts 451-2 and 452-2 may be formed separately, and the first sweeper parts 451-1 and 452-1 and the second sweeper parts 451-2 and 452-2 may be the same in thickness in the height direction (e.g., thickness in the Z-axis direction of FIG. 4B). However, as described above, the foregoing is merely for ease of description, and the first sweeper parts 451-1 and 452-1 and the second sweeper parts 451-2 and 452-2 may have various shapes.

In an embodiment, the first seating part 441 and the second seating part 442 may be the same or different in surface height, based on the direction (e.g., the Z-axis direction of FIG. 4B) perpendicular to the folding axis (e.g., the folding axis A of FIG. 3B). When the surface height of the first seating part 441 and the surface height of the second seating part 442 according to an embodiment are different, the surface of the first seating part 441 and the surface of the second seating part 442 may be formed to be stepped, based on the direction (e.g., the Z-axis direction of FIG. 4B) perpendicular to the folding axis (e.g., the folding axis A of FIG. 3B). For example, the surface height of the first seating part 441 (e.g., the height of the first seating part 441 in the +Z-axis direction of FIGS. 4D and 4F) where the hinge assembly 430 and the housings 410 and 420 overlap may be lower than the surface height of the second seating part 442 (e.g., the height of the second seating part 442 in the +Z-axis direction of FIGS. 4E and 4F) where the hinge assembly 430 and the housings 410 and 420 do not overlap.

As in FIGS. 4A to 4F, if the surface height of the first seating part 441 is lower than the surface height of the second seating part 442, and the thickness of the first sweeper parts 451-1 and 452-1 is the same as the thickness of the second sweeper parts 451-2 and 452-2, the surface height of the first sweeper parts 451-1 and 452-1 may be lower than the surface height of the second sweeper parts 451-2 and 452-2. In an embodiment, as the surface height h1 in the portions overlapping the hinge assembly 430 is formed lower than the surface height h2 in the portions not overlapping the hinge assembly 430, contact between the hinge assembly 430 and the sweepers may be prevented or reduced.

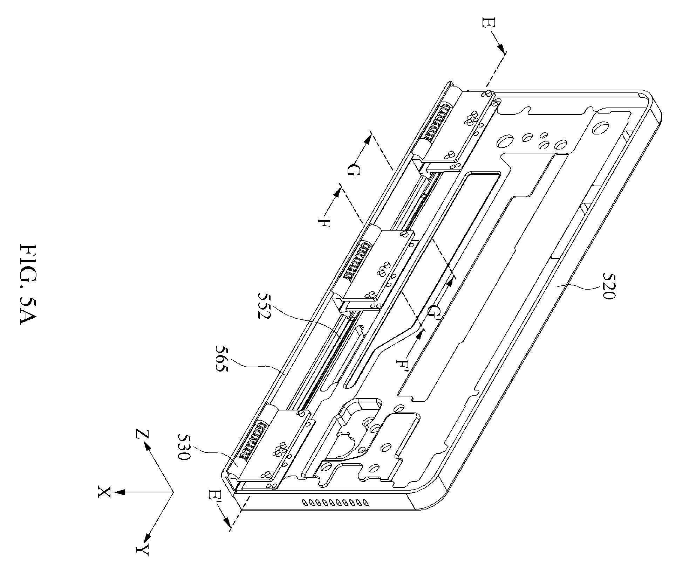

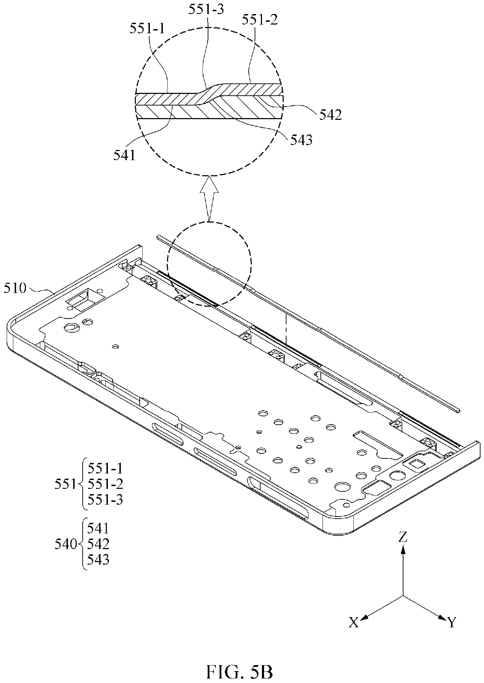

In FIG. 5A and other following drawings, a modified example of the embodiment described above about the structures of the seating portion and the sweepers will be described. In describing the structures of a seating portion and sweepers, the description described above will not be repeated. Additionally, unless otherwise specified, it may be understood that like terms as mentioned above refer to like elements unless otherwise described. The structures applied to a second housing shown in FIG. 5A and a first housing shown in FIG. 5B may be equally applied to the first housing and the second housing, respectively.

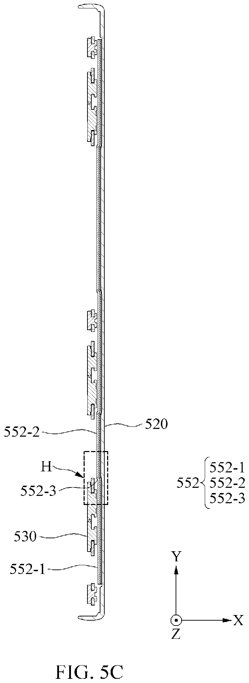

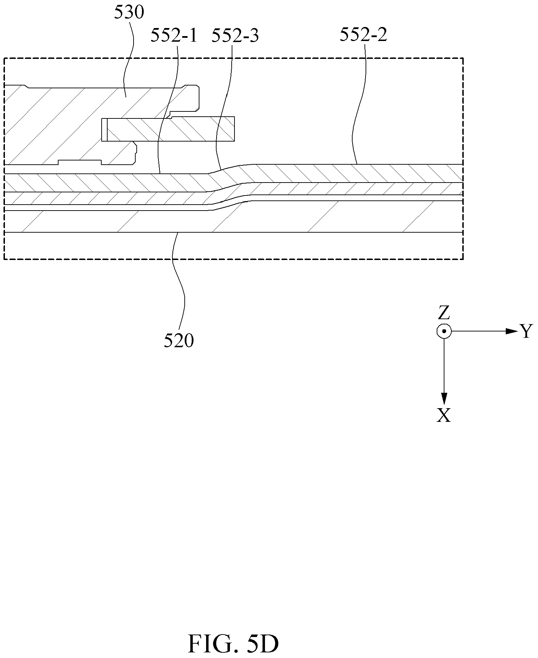

FIG. 5A is a view illustrating a structure in which a second housing, a hinge housing, a hinge assembly, and a second sweeper member are assembled, in a folded state of an electronic device according to an embodiment, FIG. 5B is an exploded perspective view to describe an arrangement relationship of a first seating part, a second seating part, and a first sweeper member formed in a first housing according to an embodiment, FIG. 5C is a cross-sectional view taken along E-E' of FIG. 5A, and FIG. 5D is an enlarged view of an area H of FIG. 5C.

Referring to FIGS. 5A to 5D, an electronic device (e.g., the electronic device 301 of FIG. 3A) according to an embodiment may include a pair of housings 510 and 520 (e.g., the pair of housings 410 and 420 of FIG. 4A), a hinge assembly 530 (e.g., the hinge assembly 430 of FIG. 4A), a hinge housing 565 (e.g., the hinge housing 465 of FIG. 4A), and sweepers 551 and 552 (e.g., the sweepers 451 and 452 of FIG. 4A) to seal the gaps formed between the hinge housing 565 and the housings 510 and 520.

The sweepers 551 and 552 according to an embodiment may include first sweeper parts 551-1 and 552-1 arranged in parts where the housings 510 and 520 overlap the hinge assembly 530, second sweeper parts 551-2 and 552-2 arranged in parts where the housings 510 and 520 do not overlap the hinge assembly 530, and third sweeper parts 551-3 and 552-3 connecting the first sweeper parts 551-1 and 552-1 and the second sweeper parts 551-2 and 552-2.

The first sweeper parts 551-1 and 552-1, the second sweeper parts 551-2 and 552-2, and the third sweeper parts 551-3 and 552-3 according to an embodiment may be formed integrally or separately. The first sweeper parts 551-1 and 552-1, the second sweeper parts 551-2 and 552-2, and the third sweeper parts 551-3 and 552-3 according to an embodiment may be the same or different in thickness in the height direction (e.g., thickness in the +Z-axis direction of FIG. 5B).

In describing the embodiment of FIGS. 5A to 5D, the description is provided assuming that the first sweeper parts 551-1 and 552-1, the second sweeper parts 551-2 and 552-2, and the third sweeper parts 551-3 and 552-3 are formed integrally and have the same thickness. However, the foregoing is merely for ease of description, and the first sweeper parts 551-1 and 552-1, the second sweeper parts 551-2 and 552-2, and the third sweeper parts 551-3 and 552-3 may be formed separately and have different thicknesses. When the sweepers 551 and 552 according to an embodiment are formed integrally, the third sweeper parts 551-3 and 552-3 may have an inclination corresponding to the difference between the surface height of the first sweeper parts 551-1 and 552-1 and the surface height of the second sweeper parts 551-2 and 552-2. However, the third sweeper parts 551-3 and 552-3 may not have an inclination and may be formed in a direction parallel to the length direction of the first sweeper parts 551-1 and 552-1 and the second sweeper parts 551-2 and 552-2.

**In** the housings 510 and 520 according to an embodiment, a seating portion 540 on which the sweepers 551 and 552 are arranged may be formed. **In** an embodiment, the seating portion 540 may include a first seating part 541 formed in a part overlapping the hinge assembly 530 and a second seating part 542 formed in a part not overlapping the hinge assembly 530. **In** an embodiment, based on a direction (e.g., the Z-axis direction of FIG. 5B) perpendicular to a folding axis (e.g., the folding axis A of FIG. 3B), the surface height of the first seating part 541 may be lower than the surface height of the second seating part 542. **In** an embodiment, the surfaces of the first seating part 541 and the second seating part 542 may be continuously connected without being stepped. For example, the seating portion 540 may include an inclined part 543 connecting the first seating part 541 and the second seating part 542.

The inclined part 543 according to an embodiment may have a surface shape that gently connects the surface height of the first seating part 541 and the surface of the second seating part 542. For example, the surface height of the inclined part 543 may decrease gradually from the second seating part 542 toward the first seating part 541 based on the height direction of the housing. **In** the inclined part 543 according to an embodiment, the third sweeper parts 551-3 and 552-3 that connect the first sweeper parts 551-1 and 552-1 arranged on the first seating part 541 and the second sweeper parts 551-2 and 552-2 arranged on the second seating part 542 and have inclinations may be arranged. The inclined part 543 according to an embodiment may have an inclination corresponding to the inclinations of the third sweeper parts 551-3 and 552-3.

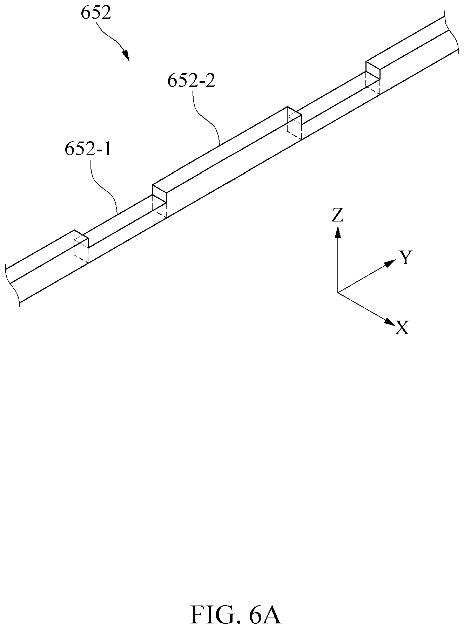

In FIG. 6A and other following drawings, an embodiment of sweepers having various shapes will be described based on a second sweeper member arranged in a second housing. The structure applied to the second sweeper member may be equally applied to a first sweeper member, and the first sweeper member may be arranged symmetrically with the second sweeper member based on a folding axis. In describing the structures of sweepers and housings in which the sweepers are arranged, the description described above will not be repeated. Additionally, unless otherwise specified, it may be understood that like terms as mentioned above refer to like elements unless otherwise described.

In FIG. 6A and other following drawings, illustrated is a spatial coordinate system defined by the X-axis, the Y-axis, and the Z-axis that are orthogonal to each other. The X-axis may represent the width direction of a second sweeper member, the Y-axis may represent the length direction of the second sweeper member, and the Z-axis may represent the height (or thickness) direction of the second sweeper member.

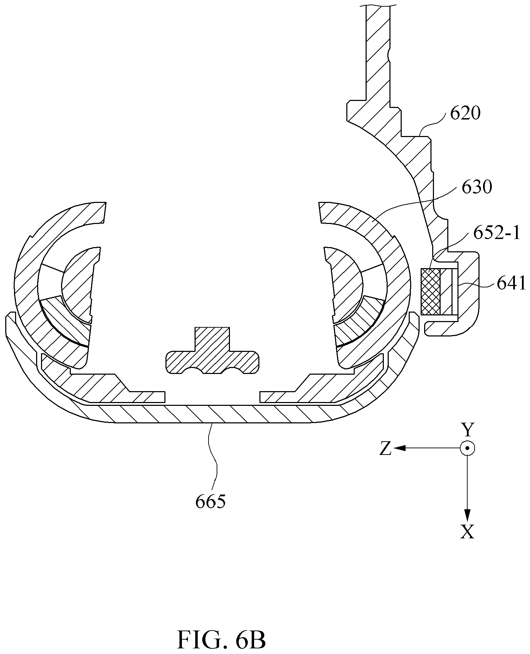

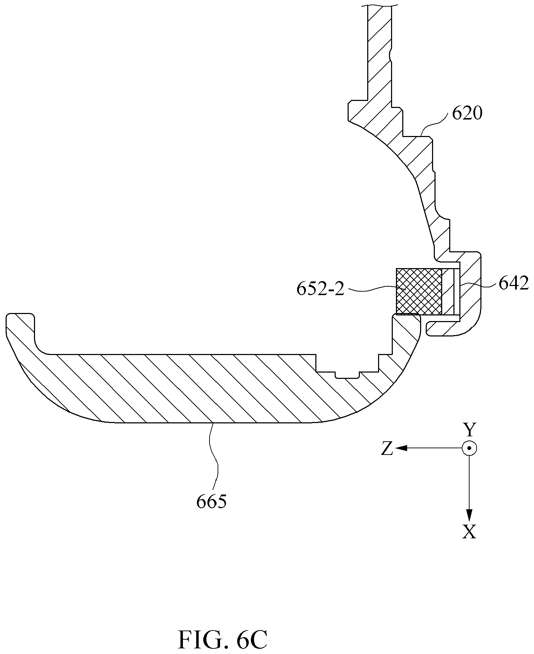

FIG. 6A is a perspective view of a second sweeper member according to an embodiment, FIG. 6B is a cross-sectional view taken along F-F', in a state in which the second sweeper member of FIG. 6A is arranged in the electronic device of FIG. 5A, and FIG. 6C is a cross-sectional view taken along G-G', in a state in which the second sweeper member of FIG. 6A is arranged in the electronic device of FIG. 5A.

An electronic device (e.g., the electronic device 301 of FIG. 3A) according to an embodiment may include a pair of housings (e.g., the pair of housings 510 and 520 of FIG. 5A), a hinge assembly 630 (e.g., the hinge assembly 530 of FIG. 5A), a hinge housing 665 (e.g., the hinge housing 565 of FIG. 5A), and sweepers (e.g., the sweepers 551 and 552 of FIGS. 5A and 5B) to seal the gaps formed between the hinge housing 665 and the housings. The sweepers according to an embodiment may include a first sweeper member (e.g., the first sweeper member 551 of FIG. 5B) arranged in a first housing (e.g., the first housing 510 of FIG. 5B) and a second sweeper member 652 (e.g., the second sweeper member 552 of FIG. 5A) arranged in a second housing 620 (e.g., the second housing 520 of FIG. 5A).

Referring to FIGS. 6A to 6C, seating portions 641 and 642 of the housings on which the second sweeper member 652 according to an embodiment is seated may include a first seating part 641 (e.g., the first seating part 541 of FIG. 5B) and a second seating part 642 (e.g., the second seating part 542 of FIG. 5B), and the first seating part 641 and the second seating part 642 may have the same surface height based on a direction (e.g., the Z-axis direction of FIG. 6B) perpendicular to the folding axis (e.g., the folding axis A of FIG. 3B). However, the foregoing is merely for ease of description, and the first seating part 641 and the second seating part 642 may have different surface heights.

The second sweeper member 652 according to an embodiment may include a first sweeper part 652-1 arranged in a part where the second housing 620 overlap the hinge assembly 630 and a second sweeper part 652-2 arranged in a part where the second housing 620 do not overlap the hinge assembly 630. The first sweeper part 652-1 and the second sweeper part 652-2 according to an embodiment may be formed integrally or separately. The first sweeper part 652-1 and the second sweeper part 652-2 according to an embodiment may be the same or different in thickness in the height direction (e.g., thickness in the +Z-axis direction of FIG. 6A).

In an embodiment, the thickness of the first sweeper part 652-1 arranged on the first seating part 641 in the height direction (e.g., the length in the +Z-axis direction of FIG. 6B) may be less than the thickness of the second sweeper part 652-2 arranged on the second seating part 642 in the height direction (e.g., the length in the +Z-axis direction of FIG. 6C). Forming the surface height of the second sweeper member 652 according to an embodiment to be lower in the part overlapping the hinge assembly 630 than the part not overlapping the hinge assembly 630 may prevent contact between the second sweeper member 652 and the hinge assembly 630.

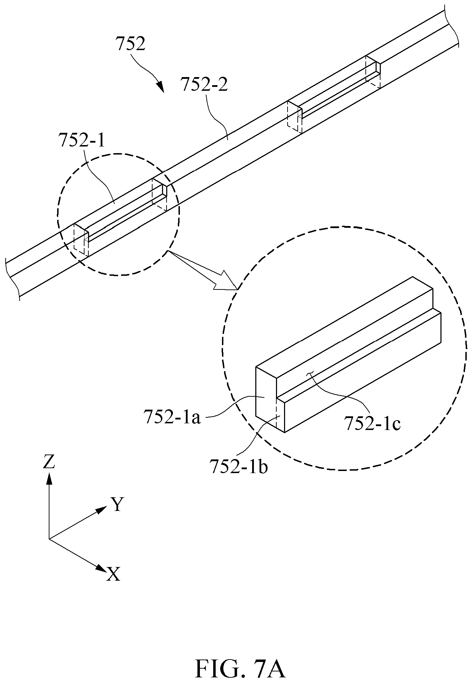

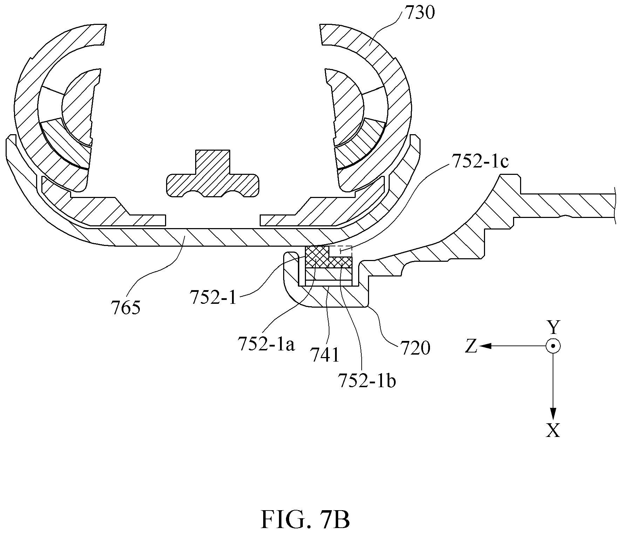

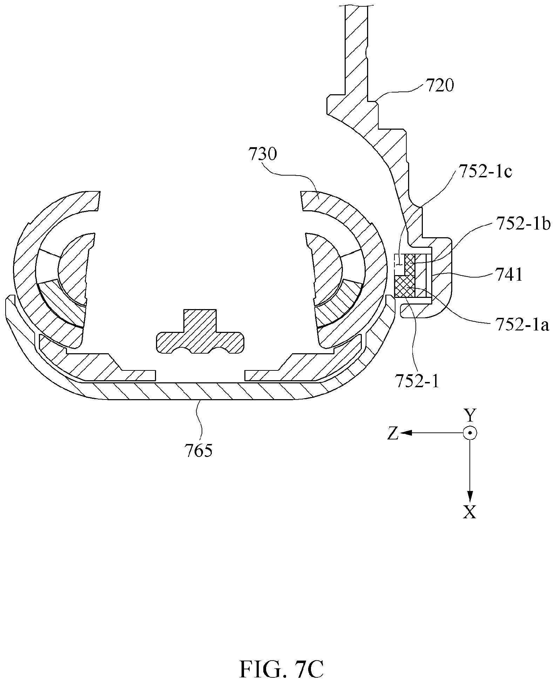

FIG. 7A is a perspective view of a second sweeper member according to an embodiment, FIG. 7B is a cross-sectional view taken along F-F' based on an unfolded state, in a state in which the second sweeper member of FIG. 7A is arranged in the electronic device of FIG. 5A, and FIG. 7C is a cross-sectional view taken along F-F' based on a folded state, in a state in which the second sweeper member of FIG. 7A is arranged in the electronic device of FIG. 5A.

Referring to FIGS. 7A to 7C, a seating portion (e.g., the seating portion 440 of FIG. 4B) of a second housing 720 (e.g., the second housing 520 of FIG. 5A), on which a second sweeper member 752 according to an embodiment is seated, may include a first seating part 741 (e.g., the first seating part 541 of FIG. 5B) and a second seating part (e.g., the second seating part 542 of FIG. 5B), and the first seating part and the second seating part may have the same surface height based on a direction (e.g., the Z-axis direction of FIG. 5B) perpendicular to a folding axis (e.g., the folding axis A of FIG. 3B). The second sweeper member 752 according to an embodiment may include a first sweeper part 752-1 arranged on the first seating part 741 and a second sweeper part 752-2 arranged on the second seating part.

In an embodiment, the first sweeper part 752-1 of the second sweeper member 752 may include an inner part 752-1a and an outer part 752-1b based on a cross section (e.g., the XZ plane of FIG. 7A) perpendicular to the length direction of the second sweeper member 752 (e.g., the Y-axis direction of FIG. 7A). In a folded state (e.g., the state of FIG. 7C) according to an embodiment, the inner part 752-1a of the second sweeper member 752 may be arranged adjacent to the hinge housing 765 (e.g., the hinge housing 565 of FIG. 5A) compared to the outer part 752-1b, based on the height direction of the second sweeper member 752 (e.g., the Z-axis direction of FIG. 7A). In an unfolded state (e.g., the state of FIG. 7B) according to an embodiment, the inner part 752-1a may be arranged adjacent to the folding axis, based on the width direction of the second sweeper member 752 (e.g., the X-axis direction of FIG. 7A). The outer part 752-1b according to an embodiment may be connected to the inner part 752-1a in the width direction of the second sweeper member 752.

In an embodiment, the recess 752-1c may be formed in the outer part 752-1b of the second sweeper member 752. In an embodiment, the recess 752-1c may be formed on a surface facing a display (e.g., the XY plane of FIG. 6B based on the unfolded state or and the YZ plane of FIG. 6B based on the folded state). In an embodiment, the thickness of the outer part 752-1b, in which the recess 752-1c is formed, in the height direction (e.g., the length in the +Z-axis direction of FIG. 7C) may be different from the thickness of the inner part 752-1a, in which the recess 752-1c is not formed, in the height direction. In an embodiment, the thickness of the inner part 752-1a of the first sweeper part 752-1 in the height direction may be substantially the same as the thickness of the second sweeper part 752-2 in the height direction.

In an embodiment, as the recess 752-1c is formed in the outer part 752-1b of the second sweeper member 752, the second sweeper member 752 may not contact the hinge assembly 730 in the process of performing the folding operation by the hinge assembly 730. In an embodiment, although the recess 752-1c formed in the outer part 752-1b is shown in a hexahedral shape, the foregoing is merely an example, and the recess 752-1c may be formed in any of various shapes that may prevent contact between the inner part 752-1a of the sweeper member and the hinge assembly 730.

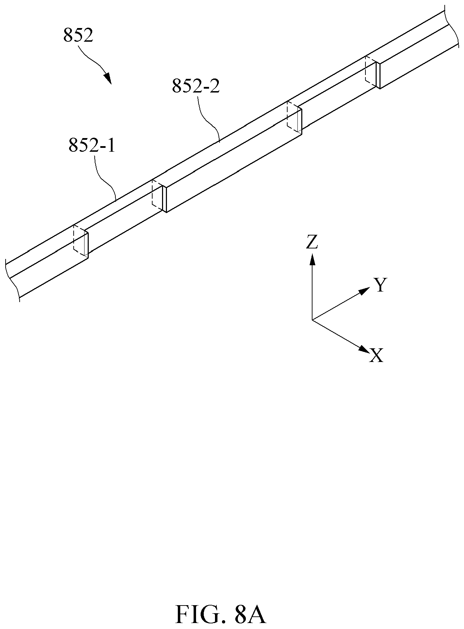

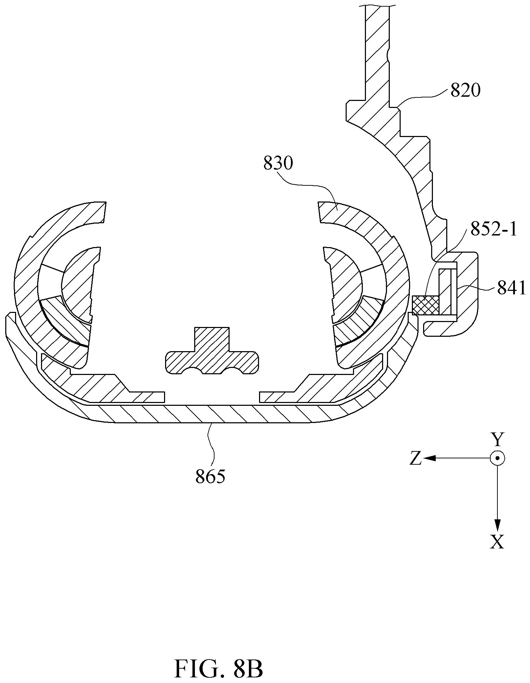

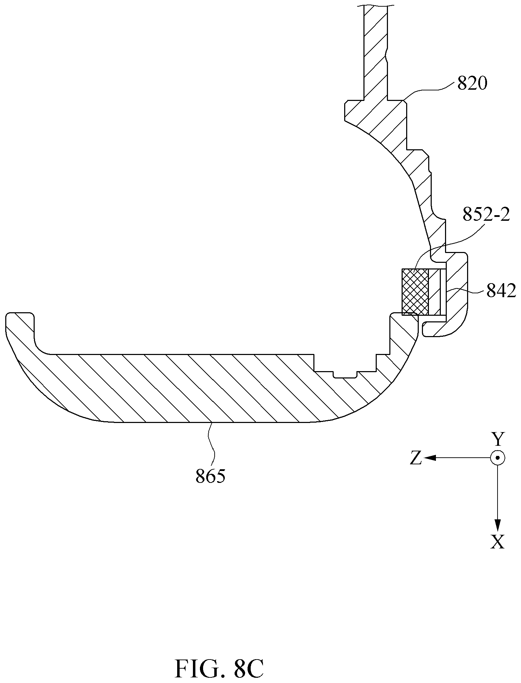

FIG. 8A is a perspective view of a second sweeper member according to an embodiment, FIG. 8B is a cross-sectional view taken along F-F', in a state in which the second sweeper member of FIG. 8A is arranged in the electronic device of FIG. 5A, and FIG. 8C is a cross-sectional view taken along G-G', in a state in which the second sweeper member of FIG. 8A is arranged in the electronic device of FIG. 5A.

Referring to FIGS. 8A to 8C, a seating portion (e.g., the seating portion 440 of FIG. 4B) of a second housing 820 (e.g., the second housing 520 of FIG. 5A), on which a second sweeper member 852 according to an embodiment is seated, may include a first seating part 841 (e.g., the first seating part 541 of FIG. 5B) and a second seating part 842 (e.g., the second seating part 542 of FIG. 5B), and the first seating part 841 and the second seating part 842 may have the same surface height (e.g., the height in the Z-axis direction of FIGS. 8B and 8C) based on a direction (e.g., the Z-axis direction of FIG. 5B) perpendicular to a folding axis (e.g., the folding axis A of FIG. 3B). The second sweeper member 852 according to an embodiment may include a first sweeper part 852-1 arranged on the first seating part 841 and a second sweeper part 852-2 arranged on the second seating part 842.

In an embodiment, the width (e.g., the length in the +X-axis direction of FIG. 8B) of the first sweeper part 852-1 of the second sweeper member 852 may be less than the width (e.g., the length in the +X-axis direction of FIG. 8C) of the second sweeper part 852-2, based on the width direction (e.g., the X-axis direction of FIG. 8A) of the second sweeper member 852. In an embodiment, the thickness of the first sweeper part 852-1 in the height direction (e.g., the length in the +Z-axis direction of FIG. 8B) may be substantially the same as the thickness of the second sweeper part 852-2 (e.g., the length in the +Z-axis direction of FIG. 8C). In an embodiment, as the first sweeper part 852-1 overlapping the hinge assembly 830 is formed to have a small width, the second sweeper member 852 may not contact the hinge assembly 830 in the process of performing a folding operation by the hinge assembly 830.

An electronic device 101;201;301 according to an embodiment includes a display 260;360 including a first area 260a;360a and a second area 260b;360b; a pair of housings 210,220;310,320;410,420;510,520 including a first housing 210;310;410;510 supporting the first area 260a;360a and a second housing 220;320;420;520;620;720;820 supporting the second area 260b;360b; a hinge assembly 330;430;530;630;730;830 connecting the first housing 210;310;410;510 and the second housing 220;320;420;520;620;720;820 to be foldable about a folding axis A; a hinge housing 265;365;465;565;665;765;865 in which at least a portion of the hinge assembly 330;430;530;630;730;830 is accommodated; and a sweeper 350;451;452;551;552;652;752;852 arranged in each of the first housing 210;310;410;510 and the second housing 220;320;420;520;620;720;820 in a direction parallel to the folding axis A, so that the first area 260a; 360a and the second area 260b; 360b contact the hinge housing 265;365;465;565;665;765;865 based on the folded state of facing each other. The sweeper 350;451;452;551;552;652;752;852 does not contact the hinge assembly 330;430;530;630;730;830, at least partially overlaps the hinge assembly 330;430;530;630;730;830 when viewed in a direction perpendicular to the folding axis A, based on the folded state, and has a surface height h1 in a portion overlapping the hinge assembly 330;430;530;630;730;830 that is lower than a surface height h2 in a portion non-overlapping the hinge assembly 330;430;530;630;730;830. In this manner, neither the overlapping portion nor the non-overlapping portion of the sweeper comes into contact with the hinge assembly, thereby preventing interference with the operation of the hinge assembly, while ensuring that no foreign substance can enter into the gap between the pair of housings and the hinge housing in the folded state, as well as contributing to efficient space utilization without requiring more space to arrange the sweeper in such a way that the hinge assembly and the sweeper are spaced apart. Further advantages are apparent to those skilled in the art.

In an embodiment, the first housing 210,310,410,510 and the second housing 220,320,420,520,620,720,820 may each include a seating portion 440,540 formed in a length direction of the pair of housings 210,220,310,320,410,420,510,520 parallel to the folding axis A so that the sweeper 350 is seated thereon, and the seating portion 440,540 may include a first seating part 441,541,641,741,841 overlapping the hinge assembly 330,430,530,630,730,830 and a second seating part 442,542,642,842 non-overlapping the hinge assembly 330,430,530,630,730,830.

In an embodiment, the first seating part 441,541 may have a lower surface height than the second seating part 442,542, based on a height direction of the pair of housings 210,220,310,320,410,420,510,520 toward the display 260,360.

In an embodiment, the sweeper 350,451,452,551,552,652,752,852 may include a first sweeper part 451-1,452-1,551-1,552-1 arranged in the first seating part 441,541, and a second sweeper part 451-2,452-2,551-2,552-2 arranged in the second seating part 442,542 and having substantially the same thickness in the height direction as the first sweeper part 451-1,452-1,551-1,552-1.

In an embodiment, the seating portion 540 may further include an inclined part 543 connecting the first seating part 541 and the second seating part 542 and having a surface height that decreases gradually from the second seating part 542 toward the first seating part 541 based on the height direction.

In an embodiment, the sweeper 551,552 may be formed integrally in a length direction of the seating portion 540, and include a first sweeper part 551-1,552-1 arranged in the first seating part 541, and a second sweeper part 551-2,552-2 arranged in the second seating part 542 and having substantially the same thickness in the height direction as the first sweeper part 551-1,552-1.

In an embodiment, the sweeper 551,552 may further include a third sweeper part 551-3,552-3 arranged in the inclined part 543 and connecting the first sweeper part 551-1,552-1 and the second sweeper part 551-2,552-2.

In an embodiment, the sweeper 652,752 may include a first sweeper part 652-1,752-1 arranged in the first seating part 641,741, and a second sweeper part 652-2,752-2 arranged in the second seating part 642, and at least a portion of the first sweeper part 652-1,752-1 may have a smaller thickness in the height direction toward the display 260,360 than the second sweeper part 652-2,752-2.

In an embodiment, the first seating part 641,741 and the second seating part 642 may have the same surface height based on the height direction.

In an embodiment, the first sweeper part 752-1, based on a cross-section perpendicular to the length direction, may include an inner part 752-1a, and an outer part 752-1b connected to the inner part 752-1a in a width direction of the sweeper 752 perpendicular to a height direction of the sweeper 752 and including a recess 752-1c formed on a surface facing the display 260,360, and the inner part 752-1a may be adjacent to the hinge housing 765 compared to the outer part 752-1b, in the folded state.

In an embodiment, a thickness of the inner part 752-1a in the height direction may be substantially the same as a thickness of the second sweeper part 752-2 in the height direction.

In an embodiment, the outer part 752-1b may include a less dense material than the inner part 752-1a.

In an embodiment, the sweeper 852 may include a first sweeper part 852-1 arranged in the first seating part 841, and a second sweeper part 852-2 arranged in the second seating part 842 and having substantially the same thickness in the height direction as the first sweeper part 852-1, and a width of the first sweeper part 852-1 may be less than a width of the second sweeper part 852-2 based on a width direction of the sweeper 852 perpendicular to the height direction of the sweeper 852.

In an embodiment, the hinge assembly 330,430,530,630,730,830 may include a hinge 333 arranged in the hinge housing 265,365,465,565,665,765,865 along the folding axis A, and a hinge bracket 331,332 connecting the hinge 333 and the pair of housings 210,220,310,320,410,420,510,520, and when the display 260,360 is viewed, the hinge bracket 331;332 may overlap the sweeper 350,451,452,551,552,652,752,852 on the first seating part 441,541,641,741,841.

In an embodiment, the hinge assembly 330,430,530,630,730,830 may be provided in plurality, and the plurality of hinge assemblies 330,430,530,630,730,830 may be arranged in the hinge housing 265,365,465,565,665,765,865 to be spaced apart from each other along the folding axis A.

An electronic device 101;201;301 according to an embodiment includes a display 260;360 including a first area 260a;360a and a second area 260b;360b; a pair of housings 210,220;310,320;410,420;510,520 including a first housing 210;310;410;510 supporting the first area 260a;360a and a second housing 220;320;420;520;620;720;820 supporting the second area 260b;360b; a hinge assembly 330;430;530;630;730;830 connecting the first housing 210;310;410;510 and the second housing 220;320;420;520;620;720;820 to be foldable about a folding axis A; a hinge housing 265;365;465;565;665;765;865 in which at least a portion of the hinge assembly 330;430;530;630;730;830 is accommodated; and a sweeper 350;451;452;551;552;652;752;852 arranged in each of the first housing 210;310;410;510 and the second housing 220;320;420;520;620;720;820 in a direction parallel to the folding axis A, so that the first area 260a; 360a and the second area 260b; 360b contact the hinge housing 265;365;465;565;665;765;865 based on the folded state of facing each other. The first housing 210;310;410;510 and the second housing 220;320;420;520;620;720;820 each include a seating portion 440;540 formed in a length direction of the pair of housings 210,220;310,320;410,420;510,520 parallel to the folding axis A so that the sweeper is seated thereon. The sweeper 350;451;452;551;552;652;752;852 does not contact the hinge assembly 330;430;530;630;730;830, at least partially overlaps the hinge assembly 330;430;530;630;730;830 when the display 260;360 is viewed from the pair of housings 210,220;310,320;410,420;510,520, based on the folded state, and has a surface height h1 in a portion overlapping the hinge assembly 330;430;530;630;730;830 that is lower than a surface height h2 in a portion non-overlapping the hinge assembly 330;430;530;630;730;830. In this manner, neither the overlapping portion nor the non-overlapping portion of the sweeper comes into contact with the hinge assembly, thereby preventing interference with the operation of the hinge assembly, while ensuring that no foreign substance can enter into the gap between the pair of housings and the hinge housing in the folded state, as well as contributing to efficient space utilization without requiring more space to arrange the sweeper in such a way that the hinge assembly and the sweeper are spaced apart. Further advantages are apparent to those skilled in the art.

In an embodiment, the seating portion 440,540 may include a first seating part 441,541 overlapping the hinge assembly 330,430,530,630,730,830 and a second seating part 442,542 non-overlapping the hinge assembly 330,430,530,630,730,830, and the first seating part 441,541 may have a lower surface height than the second seating part 442,542, based on the height direction.

In an embodiment, the seating portion 540 may further include an inclined part 543 connecting the first seating part 541 and the second seating part 542 and having a surface height that decreases gradually from the second seating part 542 toward the first seating part 541 based on the height direction.

An electronic device 101;201;301 according to an embodiment includes a display 260;360 including a first area 260a;360a and a second area 260b;360b; a pair of housings 210,220;310,320;410,420;510,520 including a first housing 210;310;410;510 supporting the first area 260a;360a and a second housing 220;320;420;520;620;720;820 supporting the second area 260b;360b; a hinge assembly 330;430;530;630;730;830 connecting the first housing 210;310;410;510 and the second housing 220;320;420;520;620;720;820 to be foldable about a folding axis A; a hinge housing 265;365;465;565;665;765;865 in which at least a portion of the hinge assembly 330;430;530;630;730;830 is accommodated; and a sweeper 350;451;452;551;552;652;752;852 arranged in each of the first housing 210;310;410;510 and the second housing 220;320;420;520;620;720;820 in a direction parallel to the folding axis A, so that the first area 260a; 360a and the second area 260b; 360b contact the hinge housing 265;365;465;565;665;765;865 based on the folded state of facing each other. The hinge assembly 330;430;530;630;730;830 includes a hinge 333 connected to the hinge housing 265;365;465;565;665;765;865 to be foldable about the folding axis A; and a hinge bracket 331;332 extending from the hinge to the pair of housings 210,220;310,320;410,420;510,520 and connecting the hinge 333 and the pair of housings 210,220;310,320;410,420;510,520. The sweeper 350;451;452;551;552;652;752;852 may include a first sweeper part 451-1;452-1;551-1;552-1;652-1;752-1 overlapping the hinge assembly 330;430;530;630;730;830; and a second sweeper part 451-2;452-2;551-2;552-2;652-2;752-2 non-overlapping the hinge assembly 330;430;530;630;730;830. At least a portion of the first sweeper part 451-1;452-1;551-1;552-1;652-1;752-1 has a smaller thickness in the height direction toward the display 260;360 than the second sweeper part 451-2;452-2;551-2;552-2;652-2;752-2. **In** this manner, neither the overlapping portion nor the non-overlapping portion of the sweeper comes into contact with the hinge assembly, thereby preventing interference with the operation of the hinge assembly, while ensuring that no foreign substance can enter into the gap between the pair of housings and the hinge housing in the folded state, as well as contributing to efficient space utilization without requiring more space to arrange the sweeper in such a way that the hinge assembly and the sweeper are spaced apart. Further advantages are apparent to those skilled in the art.

In an embodiment, the first sweeper part 451-1,452-1,551-1,552-1,652-1,752-1 may include a material different in density from that of the second sweeper part 451-2,452-2,551-2,552-2,652-2,752-2.

## Claims

1. An electronic device (101;201;301) comprising:
a display (260;360) comprising a first area (260a;360a) and a second area (260b;360b);
a pair of housings (210,220;310,320;410,420;510,520) comprising a first housing (210;310;410;510) supporting the first area (260a;360a) and a second housing (220;320;420;520;620;720;820) supporting the second area (260b;360b);
a hinge assembly (330;430;530;630;730;830) connecting the first housing (210;310;410;510) and the second housing (220;320;420;520;620;720;820) to be foldable about a folding axis (A);
a hinge housing (265;365;465;565;665;765;865) in which at least a portion of the hinge assembly (330;430;530;630;730;830) is accommodated; and
a sweeper (350;451;452;551;552;652;752;852) arranged in each of the first housing (210;310;410;510 and the second housing (220;320;420;520;620;720;820) in a direction parallel to the folding axis (A), so that the first area (260a; 360a) and the second area (260b; 360b) contact the hinge housing (265;365;465;565;665;765;865) based on the folded state of facing each other, wherein
the sweeper (350;451;452;551;552;652;752;852)
does not contact the hinge assembly (330;430;530;630;730;830),
at least partially overlaps the hinge assembly (330;430;530;630;730;830) when viewed in a direction perpendicular to the folding axis (A), based on the folded state, and
has a surface height h1 in a portion overlapping the hinge assembly (330;430;530;630;730;830) that is lower than a surface height h2 in a portion non-overlapping the hinge assembly (330;430;530;630;730;830).

2. The electronic device (101;201;301) of claim 1, wherein
the first housing (210;310;410;510) and the second housing (220;320;420;520;620;720;820) each comprise a seating portion (440;540) formed in a length direction of the pair of housings (210,220;310,320;410,420;510,520) parallel to the folding axis (A) so that the sweeper (350) is seated thereon, and
the seating portion (440;540) comprises a first seating part (441;541;641;741;841) overlapping the hinge assembly (330;430;530;630;730;830) and a second seating part 442;542;642;842) non-overlapping the hinge assembly (330;430;530;630;730;830).

3. The electronic device (101;201;301) of claim 1 or 2, wherein
the first seating part (441;541) has a lower surface height than the second seating part (442;542), based on a height direction of the pair of housings (210,220;310,320;410,420;510,520) toward the display (260;360).

4. The electronic device (101;201;301) of any one of claims 1 to 3, wherein
the sweeper (350;451;452;551;552;652;752;852) comprises:
a first sweeper part (451-1;452-1;551-1;552-1) arranged in the first seating part (441;541); and
a second sweeper part (451-2;452-2;551-2;552-2) arranged in the second seating part (442;542) and having substantially the same thickness in the height direction as the first sweeper part (451-1;452-1;551-1;552-1).

5. The electronic device (101;201;301) of any one of claims 1 to 4, wherein
the seating portion (540) further comprises an inclined part (543) connecting the first seating part (541) and the second seating part (542) and having a surface height that decreases gradually from the second seating part (542) toward the first seating part (541) based on the height direction.

6. The electronic device (101;201;301) of any one of claims 1 to 5, wherein
the sweeper (551;552) is formed integrally in a length direction of the seating portion (540), and comprises:
a first sweeper part (551-1;552-1) arranged in the first seating part (541); and
a second sweeper part (551-2;552-2) arranged in the second seating part (542) and having substantially the same thickness in the height direction as the first sweeper part (551-1;552-1).

7. The electronic device of any one of claims 1 to 6, wherein
the sweeper (551;552) further comprises a third sweeper part (551-3;552-3) arranged in the inclined part (543) and connecting the first sweeper part (551-1;552-1) and the second sweeper part (551-2;552-2).

8. The electronic device (101;201;301) of any one of claims 1 to 7, wherein
the sweeper (652;752) comprises:
a first sweeper part (652-1;752-1) arranged in the first seating part (641;741); and
a second sweeper part (652-2;752-2) arranged in the second seating part (642), and
at least a portion of the first sweeper part (652-1;752-1) has a smaller thickness in the height direction toward the display (260;360) than the second sweeper part (652-2;752-2).

9. The electronic device (101;201;301) of any one of claims 1 to 8, wherein
the first seating part (641;741) and the second seating part (642) have the same surface height based on the height direction.

10. The electronic device (101;201;301) of any one of claims 1 to 9, wherein
the first sweeper part (752-1), based on a cross-section perpendicular to the length direction, comprises:
an inner part (752-1a); and
an outer part (752-1b) connected to the inner part (752-1a) in a width direction of the sweeper (752) perpendicular to a height direction of the sweeper (752) and comprising a recess (752-1c) formed on a surface facing the display (260;360), and
the inner part (752-1a) is adjacent to the hinge housing (765) compared to the outer part (752-1b), in the folded state.

11. The electronic device (101;201;301) of any one of claims 1 to 10, wherein
a thickness of the inner part (752-1a) in the height direction is substantially the same as a thickness of the second sweeper part (752-2) in the height direction.

12. The electronic device of any one of claims 1 to 11, wherein
the outer part (752-1b) comprises a less dense material than the inner part (752-1a).

13. The electronic device (101;201;301) of any one of claims 1 to 12, wherein
the sweeper (852) comprises:
a first sweeper part (852-1) arranged in the first seating part (841); and
a second sweeper part (852-2) arranged in the second seating part (842) and having substantially the same thickness in the height direction as the first sweeper part (852-1), and
a width of the first sweeper part (852-1) is less than a width of the second sweeper part (852-2) based on a width direction of the sweeper (852) perpendicular to the height direction of the sweeper (852).

14. The electronic device (101;201;301) of any one of claims 1 to 13, wherein
the hinge assembly (330;430;530;630;730;830) comprises:
a hinge (333) arranged in the hinge housing (265;365;465;565;665;765;865) along the folding axis (A); and
a hinge bracket (331;332) connecting the hinge (333) and the pair of housings (210,220;310,320;410,420;510,520), and
when the display (260;360) is viewed, the hinge bracket (331;332) overlaps the sweeper (350;451;452;551;552;652;752;852) on the first seating part (441;541;641;741;841).

15. The electronic device (101;201;301) of any one of claims 1 to 14, wherein
the hinge assembly (330;430;530;630;730;830) is provided in plurality, and
the plurality of hinge assemblies (330;430;530;630;730;830) are arranged in the hinge housing (265;365;465;565;665;765;865) to be spaced apart from each other along the folding axis (A).
